Europäisches Patentamt

(19) European Patent Office    (11) Publication number:    **0 189 636**

Office européen des brevets    **A1**

(12)    # EUROPEAN PATENT APPLICATION

(21) Application number: **85307162.9**    (51) Int. Cl.⁴: **H 01 L 21/205**
    **H 01 L 31/02**

(22) Date of filing: **07.10.85**

(30) Priority: **02.11.84 US 667659**
    **13.02.85 US 701320**

(43) Date of publication of application:
    **06.08.86 Bulletin 86/32**

(84) Designated Contracting States:
    **CH DE FR GB IT LI NL**

(71) Applicant: **SOVONICS SOLAR SYSTEMS**
    **6180 Cochran Road**
    **Solon Ohio 44139(US)**

(72) Inventor: **Guha, Subhendu**
    **Apartment No. 17 629 West Maple Road**
    **Clawson Michigan 48017(US)**

(72) Inventor: **Kulman, James**
    **15894 Saratoga**
    **Detroit Michigan 48205(US)**

(74) Representative: **Jackson, Peter Arthur et al,**
    **GILL JENNINGS & EVERY 53-64 Chancery Lane**
    **London WC2A 1HN(GB)**

(54) Fluorinated p-doped microcrystalline semiconductor alloys and method of preparation.

㊼ A fluorinated, boron-doped p-type silicon-based semiconductor microcrystalline alloy containing a sufficient concentration of crystalline inclusions to improve material properties substantially and a method of preparing the alloy. Single and multiple cell photovoltaic devices including the alloy in at least one layer exposed to incoming light have improved fill factors and efficiencies.

EP 0 189 636 A1

FLUORINATED P-DOPED MICROCRYSTALLINE    0189636
SEMICONDUCTOR ALLOYS AND METHOD OF PREPARATION

Amorphous thin film semiconductor alloys have gained growing acceptance as a material from which to fabricate electronic devices such as photovoltaic cells, photoresponsive and photoconductive devices, transistors, diodes, integrated circuits, memory arrays and the like. Amorphous thin film semiconductor alloys can be manufactured at relatively low cost, possess a wide range of controllable electrical, optical and structural properties and can be deposited over relatively large areas. Among the semiconductor alloy materials of the greatest significance are silicon, germanium and silicon-germanium based alloys.

As disclosed in U.S. Patent No. 4,226,898, fluorine introduced into amorphous silicon alloy semiconductor materials substantially reduces the density of localized defect states in its energy gap and facilitates the addition of other alloying materials, such as germanium.

High quality n-doped and intrinsic amorphous semiconductor alloy films can be readily manufactured. However, the p-doped amorphous semiconductor alloy films of good electronic quality are much more difficult to prepare.

The invention concerns semiconductor materials in amorphous and mixed amorphous and crystalline states. As used here, "amorphous" materials means materials exhibiting long range disorder, although they may include short or intermediate range order or even contain crystalline inclusions. As used here, "microcrystalline" materials means a class of amorphous materials including a volume fraction of crystalline inclusions exceeding a threshold value. When the threshold volume fraction of crystalline inclusions is exceeded, substantial changes in certain key material parameters, such as electrical conductivity, band gap and absorption constant, occur. The onset of this critical threshold value for the substantial change in physical properties of microcrystalline materials will depend upon the size, shape and orientation of the particular crystalline inclusions, but is relatively constant for different types of materials. While many materials may be broadly classified as "microcrystalline", those materials will not exhibit the properties we have found advantageous for the practice of our invention unless they have a volume fraction of crystalline inclusions that exceeds the threshold value necessary for substantial change. The shape of the crystalline inclusions is critical to the volume fraction necessary to reach the threhold value. There are models of one, two and three dimensions that predict the volume fraction of inclusions necessary to reach the threshold value dependent on the shape of the crystalline inclusions. For instance, in one dimensional model (which may be analogized to the flow of charge carriers through a thin wire), the volume fraction of inclusions in the amorphous network must be 100 percent to reach the threshold value. In a two dimensional model (which may be viewed as substantially conically shaped inclusions extending through the thickness of the amorphous network), the volume fraction of inclusions in the amorphous network must be about 45 percent to reach the threshold value. In a three dimensional model (that may be viewed as substantially spherically shaped inclusions in a sea of amorphous material), the volume fraction of inclusions need only be about 16-19 percent to reach the threshold value. Therefore, amorphous materials (even materials classified as microcrystalline by others in the field) may include crystalline inclusions without being microcrystalline as that term is defined here.

We have recognized that the particularly advantageous properties exhibited by microcrystalline semiconductor alloy materials can be further enhanced by the inclusion of fluorine in a silicon:hydrogen semiconductor alloy matrix and that microcrystalline semiconductor alloy materials (as we have described them), with or without the addition of fluorine, have particular utility in the fabrication of n-i-p type photovoltaic devices.

In a paper entitled "High-Conductivity and Wide Optical-Gap Boron-Doped Si:H Films", Matsuda et al. describe a glow discharge deposition technique for the preparation of thin films of boron doped, hydrogenated microcrystalline silicon alloy material from a gaseous precursor mixture of diborane, silane and hydrogen under high power, low pressure conditions. The resultant p-doped semiconductor alloy was reported to have an optical gap of 1.8 eV, a dark conductivity of about 0.1 $ohm^{-1}cm^{-1}$, an activation energy of 0.03eV, and microcrystalline inclusions amounting to 60 volume percent in the amorphous network. The reported conductivity of 0.1 $ohm^{-1}cm^{-1}$ is at least two orders of magnitude below the conductivity of alloys according to our invention. The band gap reported by Matsuda is narrower than that of the corresponding intrinsic semiconductor alloy material. The technique described by Matsuda et al. fails to incorporate fluorine into the semiconductor alloy material, relies exclusively upon the use of diborane as the gaseous precursor for p-doping and fails to provide an optimized volume percentage of crystalline inclusions. Diborane is a relatively expensive, toxic, gaseous material that ignites spontaneously upon contact with the atmosphere and inherently produces undesirable semiconductor species in a glow discharge process. In a glow discharge process diborane has a tendency to incorporate polymeric and oligomeric boron species into the depositing semiconductor alloy material deleteriously affecting the chemical, optical and electronic properties of the deposited semiconductor alloy material.

The thin film p-doped semiconductor alloy material fabricated by Matsuda et al. is said to contain approximately 60 volume percent crystalline inclusions. But these results are derived from a film, not a device. In order to measure the volume fraction of crystalline inclusions in a film accurately, the film must be relatively thick, for example, 100 nanometers, whereas Matsuda's film was only 10 nanometers thick. Further, since the volume percent of crystalline inclusions increases with thickness, it is not likely that Matsuda reached the threshold value to produce microcrystalline material as we have defined it.

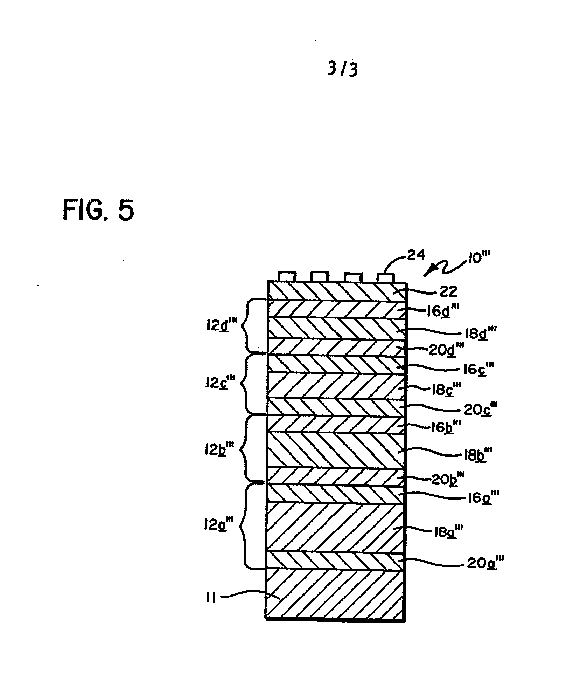

Nakamura, et al., "Tandem Type Amorphous Solar Cell", Technical Digest of the International P.V.S.E.C.-1, Kobe, Japan (Nov. 1984) pp. 587-590 and in "Tandem Type Amorphous Solar Cells", Journal of Non-Crystalline Solids, Vol. 59 and 60 (1983), pp. 1111-1114, disclose a photovoltaic device formed of three tandem silicon-containing solar cells. The photovoltaic devices of Nakamura, et al. are described as either n-i-p or p-i-n type photovoltaic cells in which the n and p doped layers are microcrystalline, i.e., formed of microcrystalline silicon:hydrogen or microcrystalline silicon:germanium:hydrogen, although the term microcrystalline is not defined. However, the material described in the Nakamura, et al. papers is not "microcrystalline" as that term is defined as used here. Evidence that Nakamura, et al.'s material is not microcrystalline comes from their Figure 5 of the Kobe Conference paper. Figure 5 shows a decrease in the optical energy gap while the dark conductivity shows a marked rise. In all measurements of our microcrystalline material as we have defined it, the optical energy gap increased with the increase in dark conductivity.

In one embodiment of our invention, a semiconductor alloy material comprises a microcrystalline host matrix containing at least silicon, fluorine and a p-doping element. The p-dopant is preferably boron. The fluorinated, p-doped, microcrystalline alloy material is characterized by an activation energy of approximately less than 0.05 eV, a conductivity of greater than 1.0 $ohm^{-1}cm^{-1}$, a band gap of approximately 2.0 eV, an absorption constant for light of 550 nanometer wavelength of approximately $3 \times 10^4 cm^{-1}$, 0.5 to 5 percent fluorine content and microcrystalline inclusions of greater than 50 volume percent. In other embodiments of the invention, the host matrix may comprise a silicon:germanium alloy and the microcrystalline semiconductor alloy material may include hydrogen.

The invention includes a method of fabricating a fluorinated, p-doped, microcrystalline semiconductor alloy material by a glow discharge deposition process. The method includes the steps of depositing the microcrystalline alloy film upon a substrate through the glow discharge decomposition of a gaseous mixture including a fluorine bearing gas, a semiconductor precursor gas, a dopant precursor gas and a diluent gas. In a preferred embodiment, the method includes the step of introducing the gaseous mixture includes less than about 10 percent of a precursor semiconductor gas, more than about 90 percent of a diluent gas and less than about 1 percent of the precursor p-dopant gas. In a preferred embodiment, the semiconductor precursor gas is silane, the diluent gas is hydrogen and the dopant precursor gas is boron trifluoride. In another embodiment, the precursor semiconductor gas is silicon tetrafluoride, the diluent gas is hydrogen and the dopant precursor gas is diborane. In still another emobodiment, the precursor semiconductor gas is silicon tetrafluoride, the diluent gas is hydrogen and the dopant precursor gas is boron trifluoride. In yet another embodiment, the precursor semiconductor gas is a silicon tetrafluoride and silane mixture, the diluent is hydrogen and the dopant precursor gas is either boron trifluoride or diborane. In still another embodiment, the precursor semiconductor gas and the precursor dopant gas are as in the foregoing embodiments, but the diluent gas comprises a mixture of hydrogen and an inert gas such as argon.

In another embodiment of the invention, an electronic device including at least one set of p-doped and n-doped semiconductor alloy regions employs a p-doped semiconductor alloy region that is fabricated of a fluorinated, microcrystalline. wide band gap semiconductor alloy material. In one particular embodiment of the electronic device, a p-doped region and an n-doped region are disposed on opposite sides of a substantially intrinsic semiconductor alloy region to form a p-i-n type photovoltaic cell. The p-doped microcrystalline semiconductor alloy material minimizes series resistance losses in the photovoltaic cell.

In another embodiment, a thin film transistor device includes at least one region formed from a fluorinated, p-doped, microcrystalline semiconductor alloy material. In still another embodiment, a CMOS thin film transistor includes at least one layer of a fluorinated, p-doped, microcrystalline semiconductor alloy material.

A further and important embodiment of the invention includes a tandem photovoltaic cell that comprises a plurality of layers of amorphous alloys deposited one on top of each other and electrically connected in series. The plurality of layers includes a plurality of electric field regions for the collection of electron-hole pairs generated the electric field regions. Light impinging on the cell structure passes sequentially through the doped layers and the electric field regions with a portion of the light being absorbed in each of the electric field regions. The plurality of doped layers includes a plurality of p-doped layers having a microcrystalline structure characterized by low optical absorption, low activation energy and high electrical conductivity.

Figure 1 is a fragmentary, cross sectional view of a tandem photovoltaic device including a plurality of p-i-n type cells.

Figure 2 is a schematic cross sectional view deposition apparatus for depositing a plurality of successive, thin film layers of semiconductor alloy material upon a continuously advancing web of substrate material.

Figure 3 is a cross sectional view of a dual band gap tandem photovoltaic device similar to the device of Figure 1, comprising two n-i-p cells.

Figure 4 is a cross sectional view of a dual band gap tandem photovoltaic device similar to the device of Figure 1 comprising three n-i-p cells.

Figure 5 is a cross sectional view of a dual band gap tandem photovoltaic device similar to the device of Figure 1 comprising four n-i-p cells.

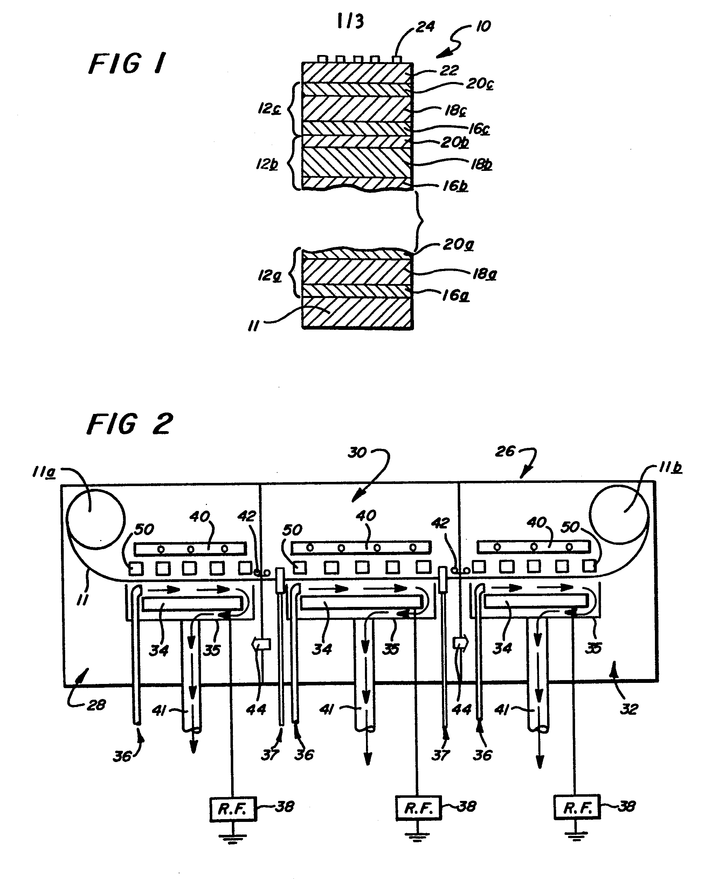

Figure 1 shows a p-i-n type photovoltaic device 10 <del>such as a</del>
solar cell, made up of individual p-i-n type cells 12a, 12b and 12c.
Adjacent cell 12a is a substrate 11 that may be transparent or formed
from a metallic material such as stainless steel, aluminum, tantalum,
molybdenum, chrome, or metallic particles embedded within an insulator.
Certain applications may require that a thin oxide layer and/or a series
of base contacts be deposited on substrate 11 prior to the application
of the amorphous material. The term substrate therefore includes not
only a flexible film, but also any elements added by preliminary
processing. Substrates may be formed of glass or a glass-like material
on which an electrically conductive electrode is applied.

Each of cells 12a, 12b and 12c are preferably fabricated with a
thin film semiconductor body containing at least a silicon alloy. Each
of the semiconductor bodies includes an n-type conductivity
semiconductor layer 20a, 20b and 20c; a substantially intrinsic
semiconductor layer 18a, 18b and 18c; and a p-type conductivity
semiconductor layer 16a, 16b and 16c. The intrinsic layer may include
traces of n-type or p-type dopant material without forfeiting its
characteristic neutrality, hence it is referred to as a "substantially
intrinsic layer". Cell 12b is an intermediate cell and, as indicated in
Figure 1, additional intermediate cells may be stacked on the
illustrated cells. The methods and materials of this invention may also
be used to produce single or multiple n-i-p cells, p-n cells, Schottky
barrier cells, as well as other semiconductor or devices such as diodes,
memory arrays, photoconductive devices and the like.

A TCO (transparent conductive oxide) layer 22 is disposed on
cell 22. An electrode grid 24 may be deposited on TCO layer 22 to
increase current collection efficiency.

In Figure 2, a multiple glow discharge deposition apparatus 26
for the continuous production of semiconductor cells including the
microcrystalline p-doped, wide band gap semiconductor alloy materials of
the invention is shown. Other apparatus may also be used to prepare the novel materials. Deposition apparatus 26 includes a plurality of isolated, deposition chambers, interconnected by gas gates 42 through which sweep gases and a web of substrate material 11 pass.

Apparatus 26 is used to deposit thin film semiconductor layers of p-i-n configuration continuously on a surface of the web of substrate material 11. Apparatus 26 includes three deposition chambers for depositing p-i-n or n-i-p cells, but additional chambers may be added or deleted to prepare more complex or simpler cells. A p-type conductivity semiconductor alloy layer is deposited in chamber 28 on the web of substrate material 11; an intrinsic semiconductor alloy layer is deposited on the p-type layer in chamber 30; and an n-type semiconductor alloy layer is deposited on the intrinsic layer in chamber 32. A coil of fresh substrate material 11a, and a take-up coil 11b of substrate material including semiconductor alloy deposits, are shown in the deposition chambers for illustrative purposes, but are generally housed in separate chambers connected to the deposition chambers. Sources of electromagnetic energy, such as radio frequency generators 38, drive the glow discharge deposition process. The energy may be direct current or alternating current at frequencies through the microwave range. It is supplied to a cathode 34 disposed in a chamber and is protected by a shield 35. The process gases may be introduced into apparatus 26 to flow in a direction parallel to and in the same or opposite direction to that of the substrate travel. The process gases are supplied through supply conduit 36. The spent gases are evacuated through evacuation conduit 41. A plurality of transversely extending magnetic elements 50 maintains web 11 in a substantially planar shape. Radiant heating elements 40 warm the substrate. An inert sweep gas conduit 37, disposed on opposed sides of intrinsic deposition chamber 30, directs an inert gas toward the dopant deposition chambers through gas gates 42 to prevent cross contamination of the reaction gas mixtures in adjacent chambers. A plasma is formed between cathodes 34 and electrically

9                                          0189636

grounded web 11 by the energy supplied by generators 38.  The plasma disassociates the process gases into species that are deposited on web substrate material 11.

We found that a p-doped, wide band gap, microcrystalline semiconductor alloy material may be readily fabricated by glow discharge deposition, provided proper gaseous precursor materials are employed and proper deposition conditions are maintained.  Care must be taken in the introduction of gaseous precursor materials because of the many competing chemical reactions that can occur in a glow discharge plasma. Some of these reactions favor the growth or deposition of the semiconductor alloy material, while other reactions favor the etching away of that deposited semiconductor alloy material.  We have found that it is necessary to control the competing chemical reactions to control the relative rates of etching and deposition.  We have found that if the rate of growth greatly exceeds the rate of etching of the depositing materials, a semiconductor alloy film not processing the required volume percentage of crystalline inclusions necessary to reach the threshold value will be deposited onto the substrate.  Of course, if the rate of etching exceeds the rate of deposition, no semiconductor alloy film will be deposited.  It is only when the growth of the semiconductor alloy material and the etching of that material occur at approximately similar rates that microcrystalline semiconductor alloy material, that is, with the required volume percentage of crystalline inclusions, will be deposited.

A typical process gas mixture comprises a gaseous precursor semiconductor material that serves to provide the semiconductor element or elements of the host matrix, one or more gaseous density of states reducing elements that serve to reduce undesired electronic states in the band gap of the semiconductor alloy, and a gaseous precursor p-dopant material that introduces the p-dopant element into the host matrix of the semiconductor alloy material.  The process gas mixture also includes a gaseous diluent, which may comprise a single component or a mixture of components, to dilute the gases and optimize the concentration and combination of reacting species into the glow discharge plasma. In some cases, the diluent gas also assists in the actual decomposition and recombination of the reacting species, and, in still other cases, the diluent gas also acts as a density of states reducing element.

We have found it necessary to employ a gaseous precursor mixture that is highly diluted to obtain the desired material. That is, we prefer a gaseous mixture in which the reacting species of gaseous precursor materials are present in relatively low concentration relative to the diluent gas. A dilute mixture permits precise control of the deposition process. Typical process gas mixtures for the practice of the invention comprise from 0.1 to 10 percent of a gaseous precursor semiconductor alloy material such as silane, or silicon tetrafluoride, alone or in combination with germane and 0.02 to 0.4 percent of a gaseous dopant material such as boron trifluoride or diborane diluted in a gaseous diluent material such as hydrogen, argon or a mixture of the two. In other words, the ratio of boron trifluoride to silane is preferably in the range of about 40 percent, while the ratio of diborane to silane is preferably in the range of 4 percent. The typical deposition parameters that are employed are a substrate temperature of about 275°C (a preferred range is 150°C to 225°C), a pressure of about 65-270 pa. and electromagnetic power density of greater than about 1.5 watts per square centimeter.

One preferred microcrystalline semiconductor alloy material comprises an alloy formed of silicon:hydrogen:fluorine doped with boron. Because the novel semiconductor alloy material is microcrystalline, it may be readily and efficiently doped to achieve an extremely low activation energy, typically in the range of about 0.05 eV. Examples of such p-doped, wide band gap, highly conductive, microcrystalline, fluorinated, hydrogenated semiconductor alloy material were prepared by the following procedures.

## Example I

A gaseous precursor mixture comprising 0.20 percent silane, 0.08 percent boron trifluoride and 99.72 percent hydrogen was introduced into a glow discharge deposition apparatus, generally similar to the deposition apparatus 26 maintained at a pressure of approximately 80 pa. The substrate was heated to approximately 225°C and energy at a frequency of 13.56 MHz at a power of 30 watts was applied to cathode 34 for 30 minutes. A semiconductor alloy film 60 nanometers thick was deposited. Raman spectroscopy and transmission electron microscopy measurements confirm that the sample was microcrystalline with crystallite sizes ranging from 5 to 10 nanometers. The volume percentage of the microcrystalline-silicon inclusions was estimated to be greater than 80 percent. This volume percentage is well above the threshold at which certain key electro-optical characteristics show marked changes. For example, this sample had a dark conductivity of approximately 5.0 $ohm^{-1}$ centimeter $^{-1}$, as compared to a dark conductivity of approximately $10^{-4}$ to $10^{-3}$ ohm $^{-1}$ centimeter $^{-1}$ for a corresponding p-doped, silicon:fluorine:hydrogen alloy having volume percentage of crystalline inclusions below the threshold value and as compared to a dark conductivity of approximately 0.1 $ohm^{-1}$ $cm^{-1}$ for a non-fluorinated microcrystalline silicon:hydrogen alloy using diborane as dopant source prepared by Matsuda, et al. The activation energy of the p-doped microcrystalline silicon alloy was less than about 0.05 eV compared to 0.4 to 0.3 eV for said corresponding amorphous p-doped, silicon:fluorine:hydrogen alloy sample. The optical band gap of said sample was 2.0 eV as compared to 1.6 eV for a corresponding silicon:hydrogen:fluorine alloy sample having a volume percentage of crystalline inclusions below the threshold value; and as compared to 1.8 eV for a p-doped, non-fluorinated, microcrystalline silicon:hydrogen alloy prepared by Matsuda, et al. The absortion constant at 550 nanometers wavelength light was $3 \times 10^4 \text{cm}^{-1}$ as compared to $1 \times 10^5 \text{cm}^{-1}$ for the p-doped silicon:hydrogen:fluorine alloy sample having a volume percentage of crystalline inclusions below the threshold value. Finally, about 3.5 percent of fluorine was incorporated into the host matrix.

Example II

In this example two photovoltaic cells of an n-i-p configuration were prepared. The two cells were identical insofar as they each consisted of a reflective stainless steel substrate having a layer of n-doped silicon alloy material deposited on it and a layer of intrinsic silicon semiconductor alloy material deposited upon the n-doped layer. The first sample then had a layer of p-doped, silicon:fluorine:hydrogen alloy material containing a volume percentage of crystalline inclusions below the threshold value, deposited on the layer of intrinsic semiconductor alloy material. The second sample had a layer of microcrystalline p-doped silicon:fluorine:hydrogen alloy material containing a volume percentage of crystalline inclusions exceeding the threshold value deposited on the layer of intrinsic semiconductor alloy material. The two photovoltaic cells thus fabricated were subjected to simulated solar illumination of approximately the intensity of the sun shining directly through the atmosphere (AM1). The photoconversion parameters of the two photovoltaic cells are summarized in Table 1 below.

## Table I

| | Layer of Microcrystalline p-doped silicon:fluorine: hydrogen alloy | Layer of Amorphous p-doped silicon:fluorine hydrogen alloy |
|---|---|---|
| Open Circuit Voltage | 0.952 Volts | 0.72 Volts |
| Short Circuit Current Density | 13.895 mA/cm$^2$ | 12.0 mA/cm$^2$ |
| Fill Factor | .712 | .58 |
| Efficiency | 9.4 percent | 5.0 percent |

Table I shows that the use of the microcrystalline, p-doped silicon:fluorine:hydrogen alloy layer improves photovoltaic cell performance in all categories of performance.

### Example III

In this example, a relatively thin n-i-p type photovoltaic cell was formed on a stainless steel substrate. This photovoltaic cell differs from the cell illustrated in and described with reference to Figure 2 insofar as it was relatively thin, i.e. only approximately 100 nanometers in total thickness. This relatively thin photovoltaic cell was specifically designed to be generally similar in thickness and chemical composition to the top cell in tandem photovoltaic devices. This cell was fabricated to show the feasibility of using the microcrystalline, p-doped, wide band gap, semiconductor alloy material of the invention as the p-doped layer in a tandem photovoltaic device. The semiconductor alloy layers were all glow discharge deposited under the conditions set forth in the foregoing Examples. We found that the relatively thin n-i-p photovoltaic cell thus produced generated an open circuit voltage of about 0.936 volts and a short circuit current density of about 9.548 $mA/cm^2$. The relatively low short circuit current density of the photovoltaic cell is attributable to its thinness. The fill factor of the photovoltaic cell was about 0.706 and the maximum power output density of the one square centimeter cell was about 6.312 $mW/cm^2$.

## Example IV

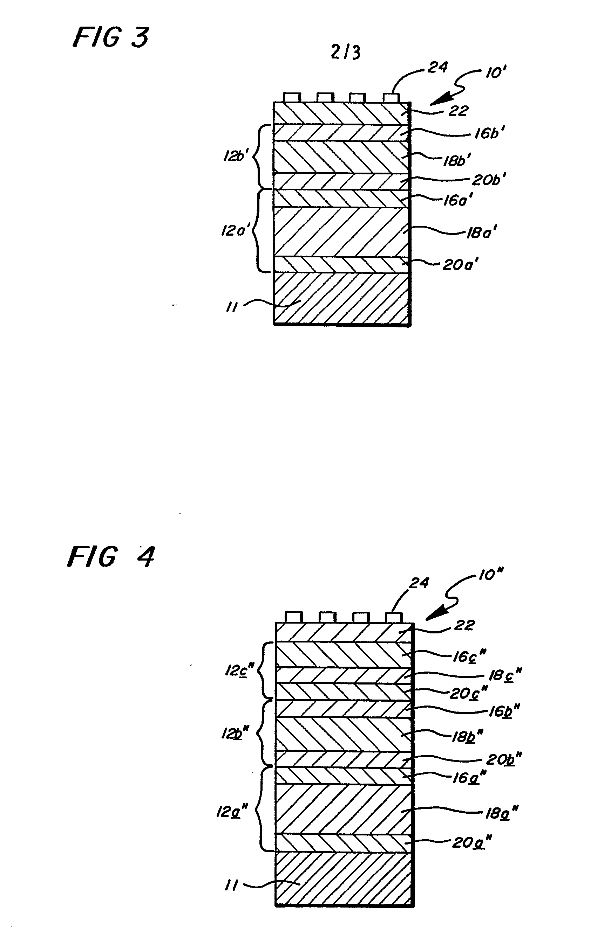

In Figure 3 a tandem photovoltaic device is shown generally by the reference numeral 10'. Tandem photovoltaic device 10' is formed of two stacked n-i-p photovoltaic cells, 12a' and 12b', each cell incorporating the layer of fluorinated microcrystalline, p-doped, wide band gap semiconductor alloy material, 16a' and 16b'.

Photovoltaic device 10' was formed by depositing a first n-doped semiconductor alloy (silicon:hydrogen:phosphorous) layer 20a' of about 25 nanometer thickness on a stainless steel substrate 11, a first intrinsic semiconductor alloy (silicon:fluorine:hydrogen:boron (in trace amounts)) layer 18a' of about 350 nanometer thickness on layer 20a', a first p-doped semiconductor alloy (silicon:fluorine:hydrogen:boron) layer 16a' of about 10 nanometer thickness on intrinsic layer 18a', a second n-doped semiconductor alloy (silicon:hydrogen:phosphorous) layer 20b' of about 10 nanometer thickness on layer 16a', a second intrinsic semiconductor alloy (silicon:fluorine:hydrogen:boron (in trace amounts)) layer 18b' of about 100 nanometers thickness on layer 20b', a second p-doped semiconductor alloy (silicon:fluorine:hydrogen:boron) layer 16b' of about 7.5 nanometers thickness on layer 18b', an ITO layer 22 of about 50 nanometers thickness on layer 16b' and grid fingers 24 on ITO layer 22. The semiconductor alloy layers were glow discharge deposited from precursor gas mixtures of: silane, hydrogen, and phosphine to form the n-doped semiconductor alloy layers; silane, hydrogen, and trace amounts of boron trifluoride to form the intrinsic semiconductor alloy layer; and silane, hydrogen and boron trifluoride to form the p-doped semiconductor alloy layers.

In this example, photovoltaic cells 12a' and 12b' were formed of semiconductor alloy materials having generally similar band gaps, i.e. were not optimized. Open circuit voltage of the tandem photovoltaic cell was about 1.821 volts and the fill factor was about 0.725, thereby indicating that a good tunnel junction was present between p-doped, wide band gap microcrystalline semiconductor alloy material layer 16a' of photovoltaic cell 12a' and n-doped semiconductor alloy material layer 20b' photovoltaic cell 12b'. While the short circuit current density of the tandem photovoltaic device was only about 6.654 mA/cm$^2$, the short circuit current density is expected to be low, since the band gaps of the two photovoltaic cells are similar. Most of the light was captured in photovoltaic cell 12b' and photovoltaic cell 12a' was unable to generate much current. Despite the relatively low short circuit current, photovoltaic device 10' operated at a photoconversion efficiency of about 8.8 percent.

Example V

In this example, an n-i-p type photovoltaic device 10' was fabricated identically to the device described with respect to Figure 3, except that photovoltaic cell, 12a', was glow discharge deposited as a narrow band gap intrinsic semiconductor alloy layer of silicon:germanium:fluorine:hydrogen:boron (in trace amounts) 18a'. Narrow band gap photovoltaic cell 12a' was fabricated by a glow discharge process generally similar to that process described with reference to Example I, however, a gaseous mixture of silane, germane, hydrogen and boron trifluoride was employed for the deposition of the layer of intrinsic silicon:germanium alloy material. The n-doped and p-doped layers of semiconductor alloy material were generally similar to those described in the foregoing examples. Cell 12a' produced an open circuit voltage of about 0.739 volts, the short circuit current density was about 18.704 $mA/cm^2$, the efficiency was about 8.51 percent, and the fill factor was 0.616.

Example VI

A tandem photovoltaic device 10" is shown in Figure 4. Tandem photovoltaic device 10" is formed of three stacked n-i-p photovoltaic cells, 12a", 12b" and 12c", each cell incorporating a layer of fluorinated, microcrystalline, p-doped, wide band gap semiconductor alloy material 16a", 16b" and 16c, respectively, of the invention.

Photovoltaic device 10" is formed by depositing a first n-doped semiconductor alloy (silicon:hydrogen:phosphorous) layer 20a" of about 30 nanometers thickness on a stainless steel substrate 11, a first intrinsic semiconductor alloy (silicon:germanium:hydrogen) layer 18a" of about 350 nanometers thickness on layer 20a", a first p-doped semiconductor alloy (silicon:fluorine:hydrogen:boron) layer 16a" of about 10 nanometers thickness on layer 18a", a second n-doped semiconductor alloy (silicon:hydrogen:phosphorous) layer 20b" of about 10 nanometers thickness on layer 16a", a second intrinsic semiconductor alloy (silicon:hydrogen) layer 18b of about 200 nanometers thickness on layer 20b", a second p-doped semiconductor alloy (silicon:fluorine:hydrogen:boron) layer 16b" of about 10 nanometers thickness on layer 18b", a third n-doped semiconductor alloy (silicon:hydrogen:phosphorous) layer 20c" of about 10 nanometers thickness on layer 16b" p-doped layer, a third intrinsic semiconductor alloy (silicon:hydrogen) layer 18c" of about 50 nanometers thickness on layer 20c", a third p-doped semiconductor alloy (silicon:fluorine:hydrogen:boron) layer 16c" of about 8 nanometers thickness on layer 18c", an ITO layer 22 of about 60 nanometers thickness on the layer 16c" and grid fingers 24 on the layer 22. The semiconductor alloy layers were glow discharge deposited from precursor gas mixtures of: silane, hydrogen, phosphine and argon to form the n-doped semiconductor alloy layers; silane, hydrogen, germane and argon to form the lowest intrinsic semiconductor alloy layer; silane, hydrogen, and argon to form the upper intrinsic semiconductor alloy layers; and silane, hydrogen, and boron trifluoride to form the p-doped semiconductor alloy layers. Layer 18a" was graded in its upper ten nanometers by depositing them without germane in the precursor gas mixture. Cell 12a" has a band gap of about 1.5 eV and second and third cells, 12b" and 12c", respectively, have band gaps of about 1.7 eV.

This cell is not optimized since the two upper cells have the same band gap. The open circuit voltage of photovoltaic cell 10" was about 2.501 volts, the fill factor was about .701, the short circuit current density was about 6.395 ma/cm$^2$ and the efficiency was 11.208 percent.

Example VII

A tandem photovoltaic device 10"' in Figure 4 is formed of four stacked n-i-p photovoltaic cells, 12a"', 12b"', 12c"' and 12d"', each cell incorporating a layer of the fluorinated, microcrystalline, p-doped, wide band gap semiconductor alloy material 16a"', 16b"', 16c"' and 16d"', respectively, of the invention.

Photovoltaic device 10"' is formed by depositing a first n-doped semiconductor alloy (silicon:hydrogen:phosphorous) layer 20a"' of about 35 nanometers thickness on a stainless steel substrate 11, a first intrinsic semiconductor alloy (silicon:germanium:hydrogen) layer 18a"' of about 350 nanometers thickness on layer 20a"', a first p-doped semiconductor alloy (silicon:fluorine:hydrogen:boron) layer 16a"' of about 10 nanometers thickness on layer 18a"', a second n-doped semiconductor alloy (silicon:hydrogen:phosphorous) layer 20b"' of about 10 nanometers thickness on layer 16a"', a second intrinsic semiconductor alloy (silicon:hydrogen) layer 18b"' of about 300 nanometers thickness on layer 20b"', a second p-doped semiconductor alloy (silicon:fluorine:hydrogen:boron) layer 16b"' of about 10 nanometers thickness on layer 18b"', a third n-doped semiconductor alloy (silicon:hydrogen:phosphorous) layer 20c"' of about 10 nanometers thickness on layer 16b"', a third intrinsic semiconductor alloy (silicon:hydrogen) layer 18c"' of about 100 nanometers thickness on layer 20c"', a third p-doped semiconductor alloy (silicon:fluorine:hydrogen:boron) layer 16c"' of about 10 nanometers thickness on layer 18c"', a fourth n-doped semiconductor alloy (silicon:hydrogen:phosphorous) layer 20d"' of about 10 nanometers thickness on 16c"', a fourth intrinsic semiconductor alloy (silicon:hydrogen) layer 18d"' of about 35 nanometers thickness on layer 20d"', a fourth p-doped semiconductor alloy (silicon:fluorine:hydrogen:boron) layer 16d"' of about 10 nanometers thickness on layer 18d"', an ITO layer 22 of about 60 nanometers thickness on layer 16d"' and grid fingers 24 on layer 22.

The semiconductor alloy layers were glow discharge deposited from precursor gas mixtures of: silane, hydrogen, phosphine and argon to form the n-doped semiconductor alloy layers; silane, hydrogen, germane and argon to form the lowest intrinsic semiconductor alloy layer; silane, hydrogen, and argon to form the upper intrinsic semiconductor alloy layers; and silane, hydrogen, and boron trifluoride to form the p-doped semiconductor alloy layers. Intrinsic semiconductor alloy layer 18a"' is graded. That is, the upper 10 nanometers of it was deposited from the aforementioned precursor gas mixture without germane. The first deposited cell, 12a"', has a band gap of about 1.5 eV and the second, third and fourth cells, 12b"' 12c"' and 12d"', respectively, have band gaps of about 1.7 eV.

19

Again, this device is not optimized by having different band gaps for each cell. Only cell 12$\underline{a}$"' is formed of a semiconductor alloy material having a band gap different from the band gap of the upper three photovoltaic cells. The four stacked n-i-p type photovoltaic cells 12$\underline{a}$"', 12$\underline{b}$"', 12$\underline{c}$"' and 12$\underline{d}$"' of this example were generally similar to the p-i-n photovoltaic cells 12$\underline{a}$", 12$\underline{b}$" and 12$\underline{c}$" that were stacked to form the photovoltaic device of Figure 4. The open circuit voltage of quad tandem photovoltaic cell 10"' was about 3.349 volts, the fill factor was about .709, the short circuit current density was about 3.203 milliamps per square centimeter and the efficiency was about 7.61 percent. Because of the thinness of the photoactive layers and the high built-in potential provided by the novel microcrystalline, p-doped semiconductor material, photo-induced degradation was virtually non-existant. The cell was still operating at 97 percent of its initial photoconversion efficiency despite over 1500 hours exposure to AM1 conditions.

In addition to the fabrication of highly efficient photovoltaic devices, the p-doped, wide band gap, microcrystalline semiconductor alloy material of the invention may be advantageously employed in the fabrication of other types of electronic devices. For example, memory arrays comprising a plurality of thin film diodes will benefit from incorporation of the microcrystalline material. Also, thin film transistors such as field effect transistors, as well as arrays of transistors, including CMOS transistors, would similarly benefit by incorporating the p-doped microcrystalline material. The microcrystalline semiconductor alloy material of the invention may also be advantageously employed to form contacts, circuit lines, bus bars and other types of conductive members employed in the manufacture of integrated circuits.

0189636

CLAIMS

1. A method of fabricating a fluorinated, p-doped microcrystalline silicon-based semiconductor alloy characterized by depositing a semiconductor alloy film by establishing a glow discharge in a gaseous mixture containing less than one percent of a semiconductor precursor gas including silicon, less than one percent of a dopant precursor gas including boron, and more than ninety percent of a diluent gas, at least one of said gases including fluorine.

2. The method of claim 1 characterized by selecting said semiconductor precursor gas from the group consisting essentially of silane, a mixture of silane and germane, silicon tetrafluoride, and a mixture of silicon tetrafluoride and germane.

3. The method of claim 1 characterized by selecting said dopant precursor gas from the group consisting essentially of boron trifluoride and diborane.

4. A photovoltaic structure including a plurality of layers (16b', 18b', 20b') of amorphous semiconductor alloy material disposed one on top of the other in optical and electrical series relationship, including a p-type conductivity layer (16b'), an intrinsic type layer (18b') and an n-type layer (20b') for establishing an electric field region in said intrinsic type layer (18b') for collection of electron-hole pairs generated in said region by absorption of impinging light, characterized in that said p-type layer (16b') is a silicon-based, fluorinated, boron doped microcrystalline layer having an activation energy of less than 0.1 electron volts, a conductivity greater than 0.5 $ohm^{-1}cm^{-1}$ and a band gap greater than 1.9 electron volts.

5. A tandem photovoltaic structure (10') including a plurality of layers (16a', 18a', 20a', 16b', 18b', 20b') of amorphous semiconductor alloy material disposed one on top of the other in optical and electrical series relationship, including a plurality of oppositely doped layers (20a', 20b', 16a', 16b') for establishing a plurality of electric field regions (18a', 18b') for collection of electron-hole pairs generated in said electric field regions by absorption of impinging light, characterized in that at least one of said doped layers (20a', 20b', 16a', 16b') is a silicon-based, fluorinated, boron doped microcrystalline layer (16b') having an activation energy of less than 0.1 electron volts, a conductivity greater than 0.5 $ohm^{-1}cm^{-1}$ and a band gap greater than 1.9 electron volts.

6.    An improved boron doped, p-type, fluorinated, silicon-based semiconductor alloy characterized in that said alloy contains microcrystalline inclusions of at least 80 percent by volume.

7.    The alloy of claim 6 characterized in that its activation energy is less than approximately 0.1 electron volts.

8.    The alloy of claim 6 characterized in that its conductivity is greater than 0.5 $ohm^{-1}cm^{-1}$.

9.    The alloy of claim 6 characterized in that its band gap is greater than 1.9 electron volts.

10.    The alloy of claim 6 characterized in that its absorption constant at 550 nanometers is less than 3 x $10^4 cm^{-1}$.

FIG 1

11/3

24

10

22

12c { 20c
18c
16c
20b
12b { 18b
16b

20a
12a { 18a
16a

11

FIG 2

11a

30

26

11b

50 40 42 50 40 42 40 50

34 35 34 35 34 35

28 41 44 37 36 41 44 37 36 41

36 37 36 32

R.F. 38 R.F. 38 R.F. 38

0189636

## FIG 3

213

- 24
- 10'
- 22
- 16b'
- 18b'
- 20b'
- 16a'
- 18a'
- 20a'
- 12b'
- 12a'
- 11

## FIG 4

- 24
- 10"
- 22
- 16c"
- 18c"
- 20c"
- 16b"
- 18b"
- 20b"
- 16a"
- 18a"
- 20a"
- 12c"
- 12b"
- 12a"
- 11

FIG. 5

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | EP-A-0 062 079 (JAPAN AS REPRESENTED BY DIRECTOR GENERAL OF AGENCY OF INDUSTRIAL SCIENCE AND TECHNOLOGY) * abstract; page 3, lines 5-13, 24; page 4, lines 1, 2; page 5, lines 13, 14; page 6, lines 13-26; page 7, lines 5-26; page 8, lines 17-19; page 13, lines 22-26; page 14, lines 7-14; page 16, lines 7-15; table 1; figure 3 * | 1-10 | H 01 L 21/205 H 01 L 31/02 |
| X | EP-A-0 111 247 (KANEGAFUCHI KAGAKU KOGYO K.K.) * abstract; page 2, lines 24-37; page 3, lines 1, 2, 17-38; page 4, lines 1-3, 27-35; page 5, lines 1-33; page 6, lines 1-33; claims 8-12, 14 * | 1-5 | |
| X | GB-A-2 135 510 (SEMICONDUCTOR ENERGY LAB. CO.LTD.) * abstract; page 3, lines 1-5, 85-120; page 5, lines 15-21; claims 4, 7, 9, 14, 15, 18, 22 * | 1-4 | TECHNICAL FIELDS SEARCHED (Int. Cl.4) H 01 L 21/205 H 01 L 31/02 |
| A | US-A-4 400 409 (MASATSUGU IZU et al.) * abstract; column 4, lines 20-63; column 6, lines 5-21; column 7, lines 1-29, 44-60 * | 1-10 | |

-/-

The present search report has been drawn up for all claims

| Place of search | Date of completion of the search | Examiner |
|---|---|---|
| BERLIN | 30-01-1986 | PRETZEL B.C. |

European Patent Office

## DOCUMENTS CONSIDERED TO BE RELEVANT

Page 2

| Category | Citation of document with indication, where appropriate, of relevant passages | Relevant to claim | CLASSIFICATION OF THE APPLICATION (Int Cl 4) |
|---|---|---|---|
| A | EP-A-0 108 492 (HITACHI, LTD.) * abstract; page 3, line 24 - page 4, line 12; page 6, lines 1-9; page 8, lines 1-3 * | 1-5 | |
| A | DE-A-2 536 174 (SIEMENS AG) * page 2, paragraphs 3, 4; page 3, last paragraph, page 9, paragraph 1; claims 1, 3 * | 1-4,6 | |
| A | APPLIED PHYSICS LETTERS, vol. 43, no. 11, 1st December 1983, pages 1045-1047, New York, US; G. RAJESWARAN et al. "substrate temperature dependence of microcrystallinity in plasma-deposited, boron-doped hydrogenated silicon alloys" | | |

TECHNICAL FIELDS
SEARCHED (Int. Cl.4)

The present search report has been drawn up for all claims

| Place of search | Date of completion of the search | Examiner |
|---|---|---|
| BERLIN | 30-01-1986 | PRETZEL B.C. |